# EUROPÄISCHE PATENTSCHRIFT

(11) **EP 1 042 809 B1**
(45) Veröffentlichungstag und Bekanntmachung des Hinweises auf die Patenterteilung: **20.02.2002**
(21) Anmeldenummer: 98963316.9
(22) Anmeldetag: 04.11.1998
(51) Int. Cl.: H01L 27/06

(54) **INTEGRIERTE SCHALTUNGSANORDNUNG SOWIE VERWENDUNG EINER SOLCHEN SCHALTUNGSANORDNUNG**
INTEGRATED CIRCUIT AND USE OF A CIRCUIT OF THIS TYPE
CIRCUIT INTEGRE ET SON APPLICATION

(30) Priorität: 18.12.1997 DE 19756603
(43) Veröffentlichungstag der Anmeldung: 11.10.2000
(73) Patentinhaber: SIEMENS AKTIENGESELLSCHAFT, 80333 München (DE)
(72) Erfinder: SWART, Marten, D-93083 Obertraubling (DE); ROTHLEITNER, Hubert, A-9500 Villach (AT)
(86) Internationale Anmeldenummer: DE9803214
(87) Internationale Veröffentlichungsnummer: WO9933112

(56) Entgegenhaltungen:
- EP-A- 0 296 348
- US-A- 4 819 560
- US-A- 5 309 841

## Beschreibung

Integrierte Schaltungsanordnung sowie Verwendung einer solchen Schaltungsanordnung.

Die Erfindung betrifft ein integrierte Schaltungsanordnung sowie eine Verwendung einer solchen integrierten Schaltungsanordnung.

Aus der EP 0 471 871 B1 ist ein Insassenschutzsystem für Kraftfahrzeuge bekannt, bei dem ein zentral im Fahrzeug angeordnetes Steuergerät über einen Datenbus bei Insassenschutzmitteln wie Airbag, Gurtstraffer, etc angeordnete Anzünder steuert. Ein jeder Anzünder weist einen in Zündmaterial eingebetteten Widerstandsheizdraht auf, der über eine steuerbare Leistungsstufe mit einem Energiespeicherkondensator verbunden ist. Eine Steuerschaltung des Anzünders empfängt über den Datenbus übermittelte Nachrichten und schaltet bei einem Zündbefehl die Leistungsstufe leitend, so daß die im Kondensator gespeicherte Energie in Form eines Stroms das Widerstandsheizelement aufheizt und damit das Zündmaterial zum Explodieren bringt. Diese freiwerdende Energie setzt wiederum in Tabletten komprimiertes Gas frei, das beispielsweise einen Airbag anfüllt.

Kondensatoren können seit einigen Jahren auch in Silizium integriert werden. Bislang zeichneten sich diese integrierten Kondensatoren jedoch durch eine relativ geringe Kapazität aus. Die Anmelderin hat deshalb eine integrierte Schaltungsanordnung mit einem Kondensator vorgeschlagen, der in seiner Speicherkapazität an herkömmliche diskret aufgebaute Kondensatoren heranreicht (V. Lehmann et al, "A novel capacitor technology based on porous silicon" in Thin Solid Films, 276 (1996), Seite 138-142). Dabei werden in einem Halbleitersubstrat - im folgenden Halbleiterschicht genannt - elektrochemisch Poren erzeugt. Die Poren werden mit einer Dielektrikumsschicht und einer Polysiliziumschicht überzogen. Die Halbleiterschicht und die Polysiliziumschicht bilden Kondensatorelektroden. Infolge der Porenbildung wird die Kondensatorkapazität bekannter integrierter Kondensatoren wesentlich erhöht.

Aufgabe der Erfindung ist es, eine aufwandsarm herzustellende kleine Zündeinheit enthaltend einen Kondensator und ein als Heizwiderstand ausgebildetes Zündeiement zu schaffen.

Gelöst wird die Aufgabe durch eine integrierte Schaltungsanordnung mit einem Kondensator und mit einem Zündelement nach Patentanspruch 1.

Eine erfindungsgemäße Verwendung der integrierten Schaltungsanordnung ist durch die Merkmale des Patentanspruchs 9 gekennzeichnet.

Vorteilhafte Weiterbildungen der Erfindung sind durch die Unteransprüche gekennzeichnet.

Die Erfindung und ihre Weiterbildungen werden anhand der Zeichnung näher erläutert. Es zeigen:
- Figuren 1 und 2: die erfindungsgemäße integrierte Schaltungsanordnung im Herstellungsprozeß,
- Figuren 3 und 4: eine erfindungsgemäße integrierte Schaltungsanordnung im Querschnitt und in Draufsicht,
- Figur 5: ein elektrisches Ersatzschaltbild der Schaltungsanordnung nach Figur 3, und
- Figur 6: einen Anzünder für ein Insassenschutzsystem unter Verwendung der integrierten Schaltungsanordnung.

Gleiche Elemente sind figurenübergreifend durch die gleichen Bezugszeichen gekennzeichnet.

In einem Ausführungsbeispiel enthält eine Halbleiterschicht 1 n-dotiertes Silizium. Die Dotierstoffkonzentration des Siliziums beträgt ca. 10¹⁸cm⁻³. Die Halbleiterschicht 1 wird mit einem ersten Spannungsanschluß verbunden und in eine Flußsäurelösung (25 Gewichtsprozent) getaucht. In der Flußsäurelösung befindet sich eine Elektrode, die mit einem zweiten Spannungsanschluß verbunden ist. Anschließend wird eine Spannung zwischen dem ersten Spannungsanschluß und dem zweiten Spannungsanschluß erzeugt, die ca. 2 Volt beträgt. Die Spannungsdifferenz zwischen dem ersten Spannungsanschluß und dem zweiten Spannungsanschluß ist positiv. Die entstehende Stromdichte beträgt ca. 100mA/cm². Nach einigen Minuten entstehen ca. 100nm breite und einige µm tiefe Poren P im Substrat 1. Nach Erreichen der gewünschten Porentiefe wird die elektrochemische Ätzung beendet. Abstände zwischen Mitten benachbarter Poren P sind etwa gleich und betragen ca. 20 nm. Die Poren P sind räumlich nicht regelmäßig angeordnet.

Zum Erzeugen einer hochdotierten Schicht 11 in der Halbleiterschicht 1 wird als Dotierstoffquelle Phosphorsilikatglas in einer Dicke von einigen nm auf eine Oberfläche O1 des ersten Substrats 1 abgeschieden. Anschließend wird durch Tempern Dotierstoff aus dem Phorphorsilikatglas etwa 100 nm tief in die Halbleiterschicht 1 ausdiffundiert, wodurch die Schicht 11 entsteht. Die Schicht 11 ist n-dotiert und ihre Dotierstoffkonzentration beträgt ca. 10²⁰cm⁻³. Die Schicht 11 ist als Kondensatorplatte für Kondensatoren geeignet.

Anschließend wird das Phosphorsilikatglas entfernt. Als Ätzmittel ist z.B. HF geeignet.

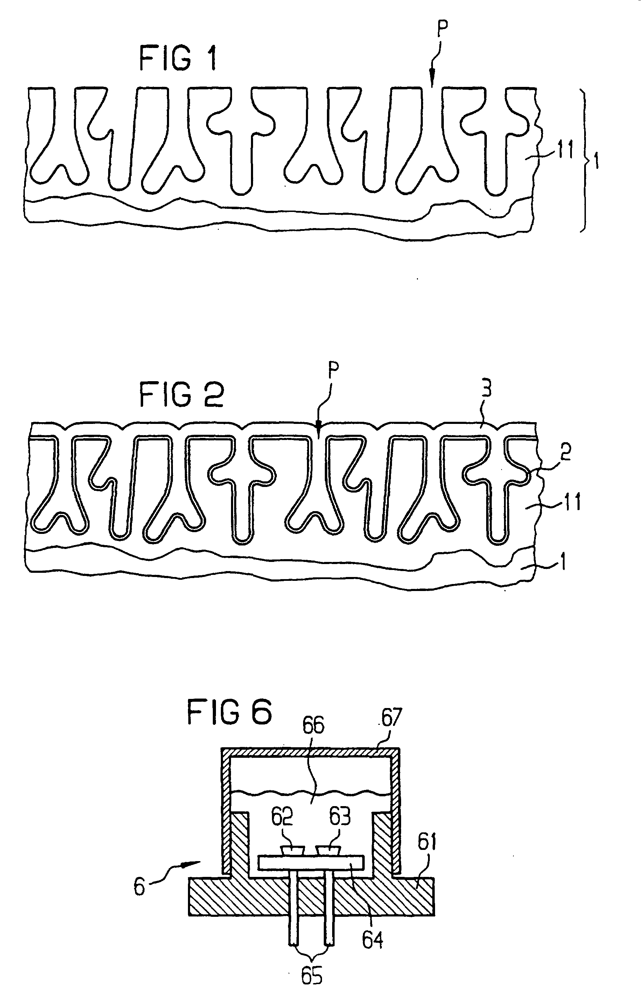

Zur Erzeugung einer Kondensatordielektrikumsschicht 2, wird eine ONO-Schicht erzeugt. Dabei steht O für Siliziumoxid und N für Siliziumnitrid. Dazu wird zunächst durch thermische Oxidation eine ca. 2nm dicke Siliziumoxidschicht aufgewachsen. Anschließend wird ca. 4nm Siliziumnitrid abgeschieden, das ca. 2nm tief aufoxidiert wird (siehe Figur 2).

Zur Erzeugung der weiteren Kondensatorelektrode wird anschließend dotiertes Polysilizium als weitere Halbleiterschicht in einer Dicke von 5nm abgeschieden (siehe Figur 2).

Ein solcher Siliziumkondensator wird näher in dem bereits in der Beschreibungseinleitung gewürdigten Fachartikel "A novel capacitor technology based on porous silicon" von V. Lehmann et al in Thin Solid Films, 276 (1996), Seite 138-142, beschrieben. Der Inhalt dieses Fachartikels, insbesondere die Kondensatorstruktur und den Herstellungsprozeß betreffend, gilt hiermit als eingeführt.

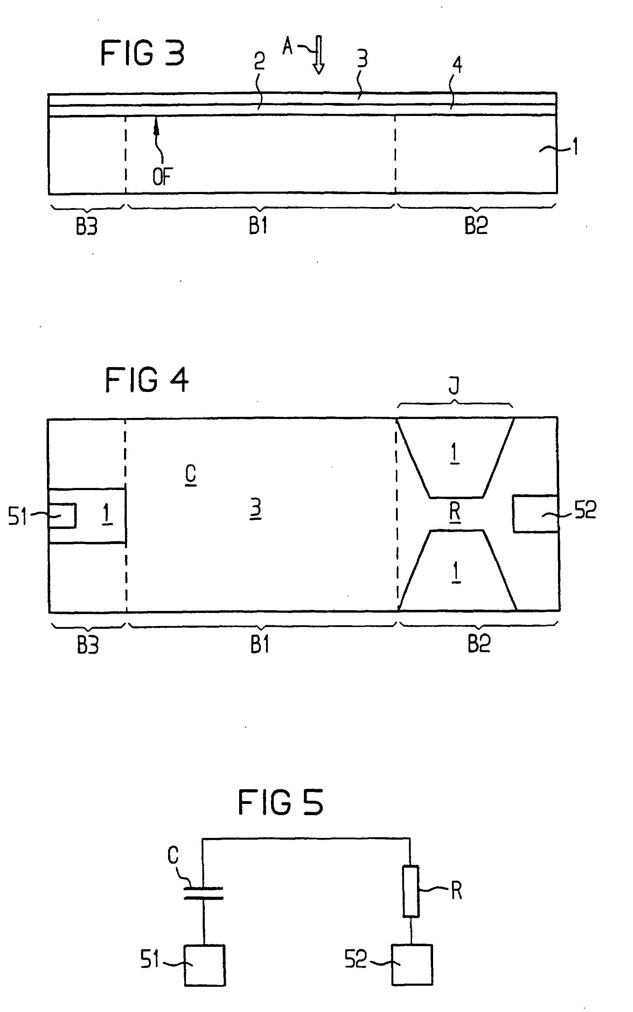

Figur 3 zeigt im Querschnitt ein Ausführungsbeispiel einer integrierten Schaltungsanordnung. Die Halbleiterschicht 1 enthält dabei einen Bereich B1, der nicht eingezeichnete Poren gemäß der Figuren 1 und 2 enthält, die mit ihrer Öffnung zur Oberfläche OF der Halbleiterschicht 1 gerichtet sind. Bereiche B2 und B3 der Halbleiterschicht 1 weisen diese Poren nicht auf. In den Bereichen B1 und B3 ist eine symbolisch angedeutete Dielektrikumsschicht 2 auf der Halbleiterschicht 1 und damit natürlich auch auf den Poreninnenwänden gemäß Figur 2 aufgebracht. Auf dieser Dielektrikumsschicht 2 ist wiederum eine als Polysiliziumschicht ausgebildete weiter Halbleiterschicht 3 angeordnet. Lediglich im nichtporösem Bereich B2 ist auf der Halbleiterschicht 1 eine Isolierschicht 4 angebracht, welche wiederum durch die Polysiliziumschicht 3 bedeckt ist.

Figur 4 zeigt eine Draufsicht auf die integrierte Schaltungsanordnung nach Figur 3 aus der Richtung A. Dabei ist insbesondere die Strukturierung der obersten Polysiliziumschicht 3 ersichtlich. Im porösen Bereich B1 des Substrats 1 bedeckt die Polysiliziumschicht 3 die darunterliegende Dielektrikumsschicht 2 zur Gänze. Polysiliziumschicht 3, Dielektrikumsschicht 2 und darunterliegende Halbleiterschicht 1 bilden in dem porösen Bereich B1 den Kondensator C, der aufgrund seiner Porenstruktur aus vielen Teilkondensatoren zusammengesetzt ist. Der nichtporöse Bereich B3 dient der elektrischen Kontaktierung der Halbleiterschicht 1. Dazu ist in diesem Bereich B3 eine Teilfläche der Polysiliziumschicht 3 und der Dielektrikumsschicht 2 abgeätzt. Auf diese auch in Figur 4 ersichtliche freigeätzte Substratfläche 1 ist eine Kontaktfläche 51 aufgebracht.

Der ebenfalls nichtporöse Bereich B2 des Substrats 1 weist ebenfalls zwei von der Polysiliziumschicht 3 und der darunterliegenden Isolierschicht 4 freigeätzte Flächen auf. Dadurch weist die Polysiliziumschicht einen in ihrem Querschnitt verjüngten Bereich J auf. Durch eine derartige Formgebung der Polysiliziumschicht 3 entsteht im Bereich B2 ein Zündelement R in Form einer Heizwiderstandsbrücke. Die derart verjüngte Stelle J stellt sicher, daß elektrische Energie in Form eines aus dem Kondensator über die verjüngten Stelle J fließenden Stroms genau an dieser verjüngten, niederohmigen Stelle J in Wärmeenergie umgesetzt wird und dadurch ein an/bei diesem verjüngten Bereich J angeordnetes Zündmaterial/Zündpulver zum Explodieren bringt. Der verjüngte Bereich J muß nicht die Form gemäß Figur 4 aufweisen. Beispielsweise kann die Verjüngung auch in einer Reduziereung der Höhe der Polysiliziumschicht besetehen. In jedem Fall ist die Querschnittsfläche der Polysiliziumschicht im verjüngten Bereich - also in dem Bereich, in dem die Heizwirkung erzielt werden soll - geringer als in dem Bereich B1, in dem die Polysiliziumschicht vornehmlich als Kondensatorelektrode wirkt.

Ferner ist im Bereich B2 eine weitere Kontaktfläche 52 auf die Polysiliziumschicht 3 aufgebracht.

Dient die Polysiliziumschicht 3 im Zusammenwirken mit der Dielektrikumsschicht 2 und dem porösen Substrat 1 im Bereich B1 als Kondensatorelektrode, so dient dieselbe Polysiliziumschicht 3 im Bereich B2 als Zündelement R. Für die erfindungsgemäße Schaltungsanordnung nach den Figuren 3 und 4 ergibt sich ein elektrisches Ersatzschaltbild nach Figur 5. Dabei ist zwischen den Kontaktflächen 51 und 52 der integrierte Siliziumkondensator C mit dem auf demselben Substrat angeordneten und dieselbe Polysiliziumschicht verwendenden Zündwiderstand R in Serie angeordnet.

Die Vorteile der erfindungsgemäßen integrierten Schaltungsanordnug liegen in ihrer kleinen Bauform und in ihrem Herstellungsverfahren in nur wenigen Herstellungsschritten. Eine aufwendig herzustellende, mechanisch und elektrisch anfällige Verbindung zwischen einem diskret aufgebauten Widerstand und einem diskret aufgebauten Kondensator entfällt. Ein einziges Bauteil enthält den Kondensator und den Widerstand, wobei der Widerstand bei der Herstellung des Kondensators ohne zusätzlichen Aufwand abfällt.

Die erfindungsgemäße integrierte Schaltungsanordnung nach dem Ausführungsbeispiel in den Figuren 3 und 4 kann natürlich auf vielfältige Weisen abgewandelt werden: So können auch die Bereich B2 und B3 Poren enthalten. Die mit der Polysiliziumschicht 3 und der Dielektrikumsschicht 2 überdeckten Flächen der Halbleiterschicht 1 tragen dann auch zur Kapazität des Kondensator C bei. Die Isolierschicht 4 im Bereich B2 ist vorzugsweise eine Siliziumoxidschicht. Dabei wird vorzugsweise eine Siliziumoxidschicht der Dielektrikumsschicht 2 verwendet. In einer weiteren Ausführungsform kann die Dielektikumsschicht 2 auch im Bereich B2 angeordnet sein. Je nach Verwendung der integrierten Schaltungsanordnung sind die dabei auftretenden Kapazitäten zwischen der Polysiliziumschicht 3 und dem nichtporösem Substrat 1 im Bereich B2 vernachlässigbar.

Die Kontaktflächen 51 und 52 können als Bondpads zur Bondanbindung an weitere elektrische Schaltungsanordnungen ausgebildet sein. Wird die integrierte Schaltungsanordnung nach Figur 3 in dieser Form auf einem Schaltungsträger angeordnet und überdeckt dabei eine Kontaktfläche auf dem Schaltungsträger, so kann die Halbleiterschicht die Kontaktfläche 51 an geeigneter Stelle zur direkten Anbindung an den Schaltungsträger angeordnet sein. Die Kontaktflächen 51 und 52 können insbesondere auch derart ausgebildet sein, daß die integrierte Schaltungsanordnung in Flip-Chip-Technik auf weitere Schaltungsanordnungen oder Schaltungsträger aufgesetzt wird.

Figur 6 zeigt eine Verwendung der erfindungsgemäßen integrierten Schaltungsanordnung 62 in einem Anzünder 6 für Insassenschutzmittel. Ein solcher Anzünder 6 ist in einem Gehäuse eines Gasgenerators angeordnet, welches wiederum mit einem aufzublasenden Luftsack mechanisch gekoppelt ist. Der Anzünder 6 enthält im wesentlichen ein Gehäuse aus einem Halter 61 und einer Kappe 67. Halter 61 und Kappe 67 bilden zusammen eine Kammer, die mit Zündmaterial 65 - insbesondere Zündpulver - angefüllt ist. Desweiteren ist im Kammerinneren auf dem Halter 61 ein Schaltungsträger 64 angeordnet, der die erfindungsgemäße integrierte Schaltungsanordnung 62 als Zündeinheit sowie eine zur Ansteuerung dieser integrierten Steuerungsanordnung 62 vorgesehene integrierte Steuerschaltung 63 enthält. Anschlußstifte 65 sind elektrisch leitend mit dem Schaltungsträger 64 verbunden und sind durch den Halter 61 geführt. Über die Anschlußstifte 65 eintreffende Nachrichten werden in der integrierten Steuerschaltung 63 ausgewertet. Soll ein Zünden des Anzünders 6 erwirkt werden, so schaltet die integrierte Steuerschaltung 63 einen nicht eingezeichneten steuerbaren Leistungsschalter leitend. Dadurch wird die Energie des Kondensators C auf den Zündwiderstand R übertragen.

Vorteilhaft bei der Verwendung der erfindungsgemäßen integrierten Schaltungsanordnung als Zündeinheit wirkt sich insbesondere aus, daß zwischen dem Zündwiderstand R und dem Kondensator C keinerlei freiliegende Leitungen geführt sind, die einen separaten Überspannungsschutz für den Zündwiderstand R zum Vermeiden von Fehlauslösungen erfordern würden.

In vorteilhafter Weise kann auch die integrierte Steuerschaltung 63 auf derselben Halbleiterschicht 1 für Kondensator C und Widerstand R angeordnet sein.

Ein typischer Widerstandsbereich für die Verwendung des Widerstands R als Heizwiderstand ist etwa 1 bis 20 Ohm. Bei einer Ausbildung des Widerstands R als Widerstandsbrücke, gemäß Figur 4 wird bei einem Stromfluß über diese Engstelle eine größtmögliche Heizwirkung und damit ein größtmöglicher Wirkungsgrad beim Zünden erreicht.

Die Kapazität des Kondensators C und damit die Ausdehnung des porösen Bereichs B1 bzw. Porentiefe und Porenabstand richten sich nach der zum Zünden des Anzünders 6 erforderlichen Energie. Die im Kondensator C abgespeicherte Energie muß also in jedem Fall ausreichen, um bei einem Leitendschalten der steuerbaren Leistungsstufe der Widerstand R ausreichend aufgeheizt werden kann. Bei einem weiteren Zündverfahren weist ein mit dem Zündwiderstand R in Serie geschalteter Kondensator C eine weitaus geringere Kapazität auf als zum Speichern einer für das Zünden des Widerstands R ausreichenden Energie erforderlich wäre. In einem Push-Pull-Verfahren wird während des Zündvorgangs der Kondensator fortwährend auf- und entladen. So werden dem Zündwiderstand R innerhalb kurzer Zeit kleine Energieportionen zugeführt. Eine jede einzelne Energieportion würde alleine nicht zum Zünden ausreichen würde, die Summe der Energieportionen über einer kurzen Zeit transportiert jedoch eine ausreichende Energiemenge zum Widerstand R.

## Patentansprüche

1. Integrierte Schaltungsanordnung mit einem Kondensator und mit einem Zündelement,
- mit einer einen porösen Bereich (B1) aufweisenden Halbleiterschicht (1) als Kondensatorelektrode,
- mit einer Dielektrikumsschicht (2) für den Kondensator, und
- mit einer weiteren Halbleiterschicht (3) als weitere Kondensatorelektrode,
- bei der die weitere Halbleiterschicht (3) einen in ihrem Querschnitt verjüngten Bereich (J) aufweist, der als elektrisch mit dem Kondensator (C) verbundenes Zündelement (R) dient.

2. Integrierte Schaltungsanordnung nach Anspruch 1, bei der die weitere Halbleiterschicht (3) als Polysiliziumschicht ausgebildet ist.

3. Integrierte Schaltungsanordnung nach Anspruch 1 oder Anspruch 2, bei der der verjüngte Bereich (J) der weiteren Halbleiterschicht (Ps) sich über einen nichtporösen Bereich (B3) des Substrats (1) erstreckt.

4. Integrierte Schaltungsanordnung nach Anspruch 4, bei der eine Kontaktfläche (51) auf einer von der Dielektrikumsschicht (2) und der weiteren Halbleiterschicht (3) freigesparten Fläche der Halbleiterschicht (1) angeordnet ist.

5. Integrierte Schaltungsanordnung nach einem der vorhergehenden Ansprüche, bei der eine weitere Kontaktfläche (52) auf der weiteren Halbleiterschicht (3) über dem nichtporösen Bereich (B2) der Halbleiterschicht (1) aufgebracht ist.

6. Integrierte Schaltungsanordnung nach einem der vorhergehenden Ansprüche, bei der der Widerstandwert im Bereich von 0,5 bis 20 Ohm liegt.

7. Integrierte Schaltungsanordnung nach einem der vorhergehenden Ansprüche, bei der die Kapazität des Kondensators (C) im Bereich größer 0,8 µF liegt.

8. Integrierte Schaltungsanordnung nach einem der Ansprüche 1 bis 7, bei der die Kapazität des Kondensators (C) im Bereichkleiner 0,8 µF liegt.

9. Integrierte Schaltungsanordnung nach einem der vorhergehenden Ansprüche, bei der die Halbleiterschicht (1) in ihrem nichtporösen Bereich (B3) durch eine Isolierschicht (4) von der weiteren Halbleiterschicht (3) getrennt ist und die Isolierschicht (4) eine Teilschicht der Dielektrikumsschicht (2) ist.

10. Verwendung einer integrierten Schaltungsanordnung nach einem der vorhergehenden Ansprüche als Zündeinheit für ein Insassenschutzmittel eines Kraftfahrzeugs,
- bei der der das Zündelement (R) bei Stromdurchfluß zum Zünden eines mit dem Zündelement (R) wärmegekoppelten Zündmaterials (66) vorgesehen ist, und
- bei der der Kondensator (C) zum Speichern elektrischer Energie zum Aufheizen des Zündelements (R) vorgesehen ist.

11. Verwendung einer integrierten Schaltungsanordnung nach Anspruch 10, bei der die Kondensatorkapazität derart bemessen ist, daß die im Kondensator (C) speicherbare Energie kleiner ist als eine zum Zünden des Zündmaterials (66) erforderliche Energiemenge.

12. Verwendung einer integrierten Schaltungsanordnung nach Anspruch 10, bei der die Kondensatorkapazität derart bemessen ist, daß die im Kondensator (C) speicherbare Energie zum Zünden des Zündmaterials (66) ausreicht.

## Claims

1. Integrated circuit arrangement having a capacitor and having an ignition element,
- having a semiconductor layer (1) as a capacitor electrode, said semiconductor layer having a porous region (B1),
- having a dielectric layer (2) for the capacitor, and
- having a further semiconductor layer (3) as a further capacitor electrode,
- in which the further semiconductor layer (3) has a region (J) which is tapered in its cross-section and which serves as an ignition element (R) electrically connected to the capacitor (C).

2. Integrated circuit arrangement according to Claim 1, in which the further semiconductor layer (3) is designed as a polysilicon layer

3. Integrated circuit arrangement according to Claim 1 or Claim 2, in which the tapered region (J) of the further semiconductor layer (Ps) extends over a non-porous region (B3) of the substrate (1).

4. Integrated circuit arrangement according to Claim 4, in which a contact area (51) is arranged on an area of the semiconductor layer (1) which has been rendered free from the dielectric layer (2) and the further semiconductor layer (3).

5. Integrated circuit arrangement according to one of the preceding claims, in which a further contact area (52) is applied on the further semiconductor layer (3) above the non-porous region (B2) of the semiconductor layer (1).

6. Integrated circuit arrangement according to one of the preceding claims, in which the resistance is in the range of from 0.5 to 20 ohms.

7. Integrated circuit arrangement according to one of the preceding claims, in which the capacitance of the capacitor (C) is in the region of greater than 0.8 µF.

8. Integrated circuit arrangement according to one of Claims 1 to 7, in which the capacitance of the capacitor (C) is in the region of less than 0.8 µF.

9. Integrated circuit arrangement according to one of the preceding claims, in which, in its non-porous region (B3), the semiconductor layer (1) is isolated from the further semiconductor layer (3) by an insulating layer (4) and the insulating layer (4) is a partial layer of the dielectric layer (2).

10. Use of an integrated circuit arrangement according to one of the preceding claims as an ignition unit for an occupant protection means of a motor vehicle,
- in which the ignition element (R) is provided, in the event of current throughflow, for the purpose of igniting an ignition material (66) thermally coupled to the ignition element (R), and
- in which the capacitor (C) is provided for the purpose of storing electrical energy for heating the ignition element (R).

11. Use of an integrated circuit arrangement according to Claim 10, in which the capacitance of the capacitor is dimensioned in such a way that the energy which can be stored in the capacitor (C) is less than a quantity of energy which is required for igniting the ignition material (66).

12. Use of an integrated circuit arrangement according to Claim 10, in which the capacitance of the capacitor is dimensioned in such a way that the energy which can be stored in the capacitor (C) suffices for igniting the ignition material (66).

## Revendications

1. Agencement de circuit intégré comportant un condensateur et un élément d'allumage, comprenant
- une couche de semiconducteur (1), comportant une zone poreuse (B1), qui constitue une électrode de condensateur,
- une couche de diélectrique (2) pour le condensateur et
- une seconde couche de semiconducteur (3) qui constitue une seconde électrode de condensateur, et dans lequel
- la seconde couche de semiconducteur (3) comporte une zone (J), d'aire de section transversale rétrécie, qui sert d'élément d'allumage (R) relié électriquement au condensateur (C).

2. Agencement de circuit intégré suivant la revendication 1, dans lequel la seconde couche de semiconducteur (3) est réalisée sous forme d'une couche de polysilicium.

3. Agencements de circuit intégré suivant la revendication 1 ou la revendication 2, dans lequel la zone rétrécie (J) de la seconde couche de semiconducteur (Ps) s'étend sur une zone non poreuse (B3) du substrat (1).

4. Agencement de circuit intégré suivant la revendication 4, dans lequel une surface de contact (51) est disposée sur une surface de la couche de semiconducteur (1) sur laquelle ont été ôtées la couche de diélectrique (2) et la seconde couche de semiconducteur (3).

5. Agencement de circuit intégré suivant l'une des revendications précédentes, dans lequel une seconde surface de contact (52) est déposée sur la seconde couche de semiconducteur (3) sur la zone non poreuse (B2) de la couche de semiconducteur (1).

6. Agencement de circuit intégré suivant l'une des revendications précédentes, dans lequel la valeur de résistance est comprise dans le domaine de 0,5 à 20 ohms.

7. Agencement de circuit intégré suivant l'une des revendications précédentes, dans lequel la capacité du condensateur (C) est située dans le domaine supérieur à 0,8 µF.

8. Agencement de circuit intégré suivant l'une des revendications 1 à 7, dans lequel la capacité du condensateur (C) est située dans le domaine inférieur à 0,8 µF.

9. Agencement de circuit intégré suivant l'une des revendications précédentes, dans lequel, dans sa zone non poreuse (B3), la couche de semiconducteur (1) est isolée de la seconde couche de semiconducteur (3) par une couche isolante (4) et la couche isolante (4) est une couche partielle de la couche de diélectrique (2).

10. Utilisation d'un agencement de circuit intégré suivant l'une des revendications précédentes en tant qu'unité d'allumage pour un dispositif de protection d'occupant d'un véhicule automobile,
- dans laquelle l'élément d'allumage (R) est prévu pour allumer, lors d'un passage de courant, une substance d'allumage (66) accouplée thermiquement à l'élément d'allumage (R) et
- dans laquelle le condensateur (C) est prévu pour accumuler une énergie électrique servant à élever la température de l'élément d'allumage (R).

11. Utilisation d'un agencement de circuit intégré suivant la revendication 10, dans laquelle la capacité du condensateur est dimensionnée d'une manière telle que l'énergie pouvant être accumulée dans le condensateur (C) est inférieure à la quantité d'énergie nécessaire à l'allumage de la substance d'allumage.

12. Utilisation d'un agencement de circuit intégré suivant la revendication 10, dans laquelle la capacité de condensateur est dimensionnée d'une manière telle que l'énergie pouvant être accumulée dans le condensateur (C) est suffisante pour l'allumage de la substance d'allumage (66).
